# EUROPÄISCHE PATENTSCHRIFT

(11) **EP 0 658 266 B1**
(45) Veröffentlichungstag und Bekanntmachung des Hinweises auf die Patenterteilung: **04.12.1996**
(21) Anmeldenummer: 93919240.7
(22) Anmeldetag: 02.09.1993
(51) Int. Cl.: G11B 15/00, G11B 15/18

(54) **VERFAHREN UND VORRICHTUNG ZUR ANSTEUERUNG MIT GEPULSTEN SIGNALEN**
PROCESS AND DEVICE FOR CONTROLLING WITH PULSED SIGNALS
PROCEDE ET DISPOSITIF DE COMMANDE AVEC DES SIGNAUX PULSES

(30) Priorität: 04.09.1992 DE 4229342
(43) Veröffentlichungstag der Anmeldung: 21.06.1995
(73) Patentinhaber: DEUTSCHE THOMSON-BRANDT GMBH, 78048 Villingen-Schwenningen (DE)
(72) Erfinder: GLEIM, Günter, D-78052 Villingen-Schwenningen (DE); LINK, Hermann, D-78052 Villingen-Schwenningen (DE); HEIZMANN, Friedrich, D-78052 Villingen-Schwenningen (DE)
(86) Internationale Anmeldenummer: EP9302364
(87) Internationale Veröffentlichungsnummer: WO9406114

(56) Entgegenhaltungen:
- EP-A- 0 231 917
- EP-A- 0 319 910
- US-A- 4 800 478

## Beschreibung

Die vorliegende Erfindung betrifft ein Verfahren gemäß dem Oberbegriff des Hauptanspruchs und eine Vorrichtung nach dem Oberbegriff des ersten Sachanspruchs.

Systeme bei denen ein Verbraucher durch gepulste Signale, wie pulsweitenmodulierte (PWM) Signale, pulslängenmodulierte (PLM) Signale oder dergleichen, angesteuert wird, sind allgemein bekannt.

Es sind auch bereits verschiedene Verfahren zur gepulsten Ansteuerung von Motoren vorgeschlagen worden. Als Beispiele seien hier die älteren Anmeldungen P 42 15 962.8, P 42 15 830.3, P 42 15 827.3 und P 42 27 761.2 genannt.

Bei einer gepulsten Ansteuerung eines Verbrauchers wechselt das Ansteuersignal immer zwischen einem ersten Zustand, der einem ersten Spannungswert, beispielsweise Null Volt, entspricht und einem zweiten Zustand, der einem zweiten Spannungswert, beispielsweise dem einer positiven Versorgungsspannung, entspricht. Denkbar ist ebenfalls ein entsprechender Wechsel zwischen verschiedenen vorgegebenen Stromwerten.

Bei einem abrupten Wechsel zwischen den beiden Zuständen tritt ein starkes Störspektrum, entsprechend dem Fourier-Spektrum, auf. Bei einem langsamen übergang von einem Zustand in den nächsten werden diese Störanteile stark reduziert.

Andererseits fallen bei einem langsamen übergang von einem der zwei Zustände in den jeweils anderen Spannungen an einer Ansteuerstufe ab, die zu einer entsprechenden Verlustleistung und damit zu einer entsprechenden Erwärmung führen. Bei einem abrupten Wechsel ist die Verlustleistung im Bereich der Schaltflanken stark vermindert.

Es ist die Aufgabe der vorliegenden Erfindung, eine Ansteuerung mit gepulsten Signalen derart weiterzuentwickeln, daß zum einen merkbare Störungen weitgehend vermieden werden, und zum anderen eine übermäßige Erwärmung verhindert wird.

Diese Aufgabe wird gelöst durch ein Verfahren gemäß dem Hauptanspruch und durch eine Vorrichtung nach dem ersten Sachanspruch.

Durch die Unteransprüche werden vorteilhafte Weiterbildungen charakterisiert.

Erfindungsgemäß wird ein Verbraucher mit einem PWM-Signal angesteuert, das Flanken verschiedener Steilheit aufweisen kann. Die Flankensteilheit kann dabei gewählt werden in Abhängigkeit von vorgegebenen Betriebsarten und/oder vorgegebenen Werten von Betriebsgrößen, wie Ansteuerstrom, Temperatur oder dergleichen.

Es ist ein Vorteil der Erfindung, daß Endstufen zur Ansteuerung von nachgeschalteten Verbrauchern kleiner dimensioniert werden können als bei bekannten Systemen. Dadurch können preiswertere Bauelemente für die Endstufen verwendet werden. Wird eine Endstufe als integrierte Schaltung realisiert, so ist ein entsprechend geringerer Platzbedarf auf der (IC-) Halbleiter-Oberfläche erforderlich, wodurch ebenfalls Kosten eingespart werden können.

Weitere Merkmale, Vorteile und Einzelheiten der Erfindung werden in den folgenden Ausführungsbeispielen anhand der Zeichnung erläutert. Dabei zeigen:
- Fig. 1 :: ein Ausführungsbeispiel zur Anwendung bei einem Videorekorder;
- Fig. 2 :: Kurvenverläufe eines Ansteuersignales gemäß Fig. 1 bei verschiedenen Betriebsarten.

Bevor auf die Beschreibung der Ausführungsbeispiele näher eingegangen wird, sei darauf hingewiesen, daß die in den Figuren einzeln dargestellten Blöcke lediglich zum besseren Verständnis der Erfindung dienen. üblicherweise sind einzelne oder mehrere dieser Blöcke zu Einheiten zusammengefaßt. Diese können in integrierter oder Hybridtechnik oder als programmgesteuerter Mikrorechner oder als Teil eines zu seiner Steuerung geeigneten Programmes realisiert sein.

Die in den einzelnen Stufen enthaltenen Elemente können jedoch auch getrennt ausgeführt werden.

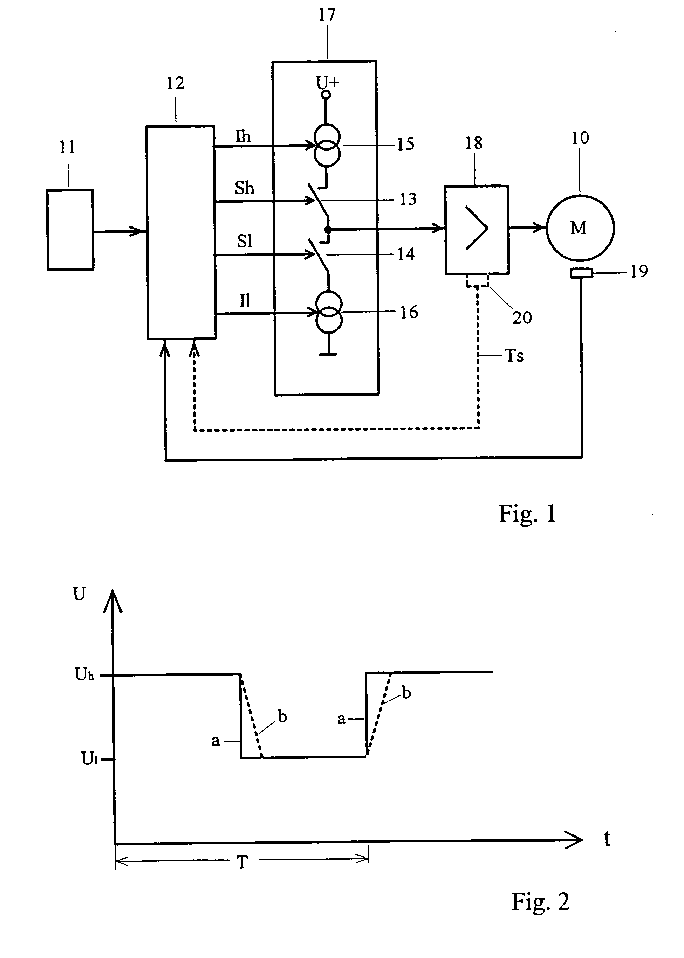

Fig. 1 zeigt symbolisch eine PWM-Ansteuerung eines (Capstan) Antriebsmotors 10, zum Beispiel die Type VMX 800 von Sony oder F2QKB30T von Sankyo, der in einem nicht dargestellten Videorekorder angeordnet ist.

Über eine Eigabeeinheit 11, beispielsweise eine Gerätetastatur oder eine Fernbedienung, kann einem Steuergerät 12, das zum Beispiel ein programmgesteuerter Mikrorechner mit der Bezeichnung TMP 90 CK 42 von Toshiba oder ein ST 9040 von Thomson sein kann, ein gewünschter Betriebsmodus vorgegeben werden, wie beispielsweise Abspielen (PLAY), Aufnehmen (RECORD), Suchlauf (SEARCH), schneller Vorlauf (FAST FORWARD), schneller Rücklauf (FAST BACKWARD), usw. Das Steuergerät 12 gibt Schaltsteuersignale Sh bzw. Sl an einen ersten Schalter 13 bzw. einen zweiten Schalter 14 ab. Weiterhin gibt das Steuergerät 12 Steuersignale Ih an eine erste Stromquelle 15 und Il an eine zweite Stromquelle 16 ab.

Die Mittel 13 bis 16 sind Teil einer PWM-Stufe 17 und derart in Reihe geschaltet, daß die erste Stromquelle 15 mit einem ersten Anschluß an eine positive Versorgungsspannung U+ angeschlossen ist und ihr zweiter Anschluß mit einem ersten Schalteingang des Schalters 13 verbunden ist. Der zweite Schalteingang des Schalters 13 führt zu einem ersten Schalteingang des Schalters 14, dessen zweiter Schalteingang über die zweite Stromquelle 16 mit Masse verbunden ist.

Die PWM-Stufe 17 ist mit einer Endstufe 18 verbunden, beispielsweise L6232 von Thomson, die den Motor 10 ansteuert, das heißt bestromt. Dessen Drehzahl und/oder Drehposition werden von einem Sensor 19 erfaßt der entsprechende Signale an das Steuergerät 12 leitet.

Die Funktion des Ausführungsbeispieles nach Fig. 1 wird im folgenden mit Hilfe der Fig. 2 erläutert.

Die PWM-Stufe 17 erzeugt pulsweitenmodulierte Signale mit einer Periode T und einem Tastverhältnis, das der gewünschten Drehzahl und Belastung des Motors 10 entspricht und von dem Steuergerät 12 aufgrund eines Regelungsverfahrens vorgegeben wird.

Bei einer ersten Ausgestaltung werden lediglich zwei Arten von PWM-Signalen erzeugt, eine erste Art mit einer steilen Flanke a zwischen den beiden Zuständen und eine zweite Art mit einer flachen Flanke b. Die Auswahl, welche Art der beiden PWM-Signale zur Ansteuerung dient, erfolgt in Abhängigkeit von einer über die Eingabestufe 11 vorgegebenen Betriebsart.

So wird bevorzugterweise bei Betriebsarten, bei denen ein Bild sichtbar ist, bzw. die steilen Flanken stören, wie beispielsweise bei Abspiel- und Aufnahmebetrieb sowie bei Suchbetrieb, das PWM-Signal mit der Flanke b gewählt und für die restlichen Betriebsarten das PWM-Signal mit der steilen Flanke a. Die Art des PWM-Signales wird von dem Steuergerät 12 dadurch eingestellt, wie die Stromquellen 15 und 16 angesteuert werden. Soll das PWM-Signal beispielsweise von dem hohen Pegel Uh auf den niedrigen Pegel Ul verändert werden, so wird der Schalter 13 geöffnet und der Schalter 14 geschlossen. Durch die vorhandene Kapazität eines in der Endstufe 18 enthaltenen Leistungstransistors wird je nach Stromwert in der Stromquelle 16 die Spannungsänderung schnell oder langsam verlaufen.

Das Umschalten von dem niedrigem Pegel Ul auf den hohen Pegel Uh erfolgt in entsprechender Weise.

Der Auswahl der Flankensteilheit zu den genannten Betriebsarten liegt die Erkenntnis zugrunde, daß bei Abspiel- und Aufnahmebetrieb sowie bei dem Suchbetrieb Bilder für einen Zuschauer sichtbar werden, die durch das von steilen Flanken verursachte Störspektrum beeinträchtigt werden können. Andererseits verbraucht der Motor 10 in diesen Betriebsarten nur eine geringe Leistung und dadurch ist die entsprechende Verlustleistung für die Endstufe 18 gering. Das heißt, daß diejenige Verlustleistung, die durch flache Flanken verursacht wird, keine übermäßige Erwärmung der Endstufe 18 bewirkt.

Es ist bei einer Variante des genannten Ausführungsbeispiels ebenfalls möglich, für den Suchbetrieb das PWM-Signal mit der steilen Flanke zu wählen. Dadurch wird der stärkeren Beanspruchung des Motors 10 Rechnung getragen und es wird in Kauf genommen, daß die derart erzeugten Bildfolgen eventuell doch Störungen aufweisen. Es ist auch möglich, für den Suchbetrieb eine dritte Art des PWM Signales zu verwenden, deren Flanke zwischen der Flanke a und der Flanke b liegt.

Bei einer weiteren Ausgestaltung dieses Ausführungsbeispiels wird der Wert des Stromes erfaßt oder ermittelt, mit dem der Motor 10 bestromt wird. Das kann entweder dadurch erfolgen, daß ein von den PWM-Signalen abgeleitetes Signal einem Tiefpaß zugeführt wird, wodurch eine Gleichspannung erzeugt wird, deren Wert ein Maß ist für den mittleren Stromwert des Motor-Ansteuersignales. Es ist ebenfalls möglich, diesen Stromwert aufgrund von Betriebsgrößen zu berechnen. Es sei an dieser Stelle besonders auf die ältere Anmeldung P 42 27 761.2 verwiesen.

In Abhängigkeit von dem erhaltenen Stromwert kann die Steilheit der Flanken abgestuft oder stufenlos eingestellt werden.

Ein zweites Ausführungsbeispiel ist in Fig. 1 durch einen gestrichelt eingezeichneten Temperatursensor 20 angedeutet, der die Temperatur der Endstufe 18 erfaßt und ein entsprechendes Signal Ts an das Steuergerät 12 abgibt.

Das zweite Ausführungsbeispiel funktioniert derart, daß die Steilheit der Flanken gesteuert wird in Abhängigkeit von der Temperatur der Endstufe 18. Weist die Endstufe 18 eine hohe Temperatur auf, so werden PWM-Signale mit einer steilen Flanke gewählt. Liegt eine niedrige Temperatur vor, so werden PWM-Signale mit einer flachen Flanke a erzeugt. Der Zwischenbereich kann abgestuft oder stufenlos eingestellt werden.

Diesem Ausführungsbeispiel liegt die Erkenntnis zugrunde, daß die Vermeidung einer überhitzung der Endstufe 18 die oberste Priorität hat. Selbst wenn der Zuschauer durch auftretende Störungen beeinträchtigt werden sollte, so bleibt die Funktionsfähigkeit des Gerätes, in diesem Fall des Videorekorders gewahrt. Weiterhin kann davon ausgegangen werden, daß in denjenigen Betriebsarten, in denen ein Bild sichtbar ist, die Belastung für den Motor 10 und die Endstufe 18 relativ gering ist. Das heißt, in diesen Betriebsbereichen werden hohe Temperaturen üblicherweise nicht erreicht. Sollte bei Beginn einer derartigen Betriebsart eine hohe Temperatur vorliegen, beispielsweise durch langes Umspulen, so wird diese nach kurzer Zeit Temperaturwerte annehmen, die derart steile Flanken bewirken, daß eine Beeinträchtigung für den Zuschauer vernachlässigbar oder nicht vorhanden ist.

Bei einer Weiterbildung dieses Ausführungsbeispiels gibt der Temperatursensor sein Signal Ts nicht an das Steuergerät 12, sondern steuert die Stromquellen 15, 16 an. Dadurch kann auf den entsprechenden Anschluß des Steuergerätes 12 verzichtet werden. Das hat beispielsweise dann einen besonderen Vorteil, wenn die PCM-Stufe 17 zusammen mit der Endstufe 18 integriert wird.

Ergänzend sei erwähnt, daß die Merkmale der genannten Ausführungsbeispiele miteinander kombiniert werden können. So ist es beispielsweise möglich, daß die Vorgabe für eine bestimmte Art des PWM-Signales zunächst aufgrund des gewünschten Modus erfolgt und im Bedarfsfall durch das Temperatursignal Ts korrigiert wird.

Versionen der genannten Ausführungsbeispiele können zumindest eine der folgenden Variationen aufweisen:
- anstelle eines Motors kann auch ein sonstiger Verbraucher mittels eines gepulsten bzw. getakteten Signales angesteuert werden. Die Steilheit der Flanken kann gewählt werden in Abhängigkeit von bestimmten Betriebsarten und/oder von den jeweiligen Werten vorgegebener Betriebsgrößen, wie beispielsweise Temperaturen, Strom, Spannung, Zeit, Feuchte, Helligkeit;
- die Flankensteilheit kann auch dadurch angesteuert werden, daß Elemente, das heißt Widerstände und/oder Kondensatoren, eines R/C-Gliedes in geeigneter Weise zugeschaltet werden. Dabei kann die Kapazität von einem oder mehreren Leistungstransistoren der Endstufe 18 berücksichtigt werden.

## Patentansprüche

1. Verfahren zur Ansteuerung eines Verbrauchers (10) mit gepulsten Signalen die zwischen einem ersten Vert (Uₕ) und einem zweiten Wert (Uₗ) entsprechend einer vorgegebenen Flanken-steilheit (a,b) variieren, dadurch gekennzeichnet, daß die Flankensteilheit vorgegeben wird in Abhängigkeit von einer gewählten Betriebsart und/oder von einer oder mehreren Betriebsgrößen.

2. Verfahren nach Anspruch 1, dadurch gekennzeichnet, daß eine erste Betriebsgröße die Temperatur einer Endstufe ist, die den Verbraucher ansteuert.

3. Verfahren nach einem der Ansprüche 1 oder 2, dadurch gekennzeichnet, daß eine zweite Betriebsgröße der Strom ist, mit dem der Verbraucher angesteuert wird.

4. Verfahren nach einem der Ansprüche 1 bis 3, dadurch gekennzeichnet, daß der Verbraucher ein Antriebsmotor eines Videorekorders ist und daß die Betriebsarten, die zur Bestimmung der Flankensteilheit dienen, die Betriebsarten des Videorekorders sind, wie Abspielbetrieb, Aufnahmebetrieb, Suchlauf, Umspulen oder dergleichen.

5. Vorrichtung zur Ansteuerung eines Verbrauchers (10) mit gepulsten Signalen, die zwischen einem ersten Wert (Uh) und einem zweiten Wert (Ul) entsprechend einer vorgegebenen Flankensteilheit (a, b) variieren, dadurch gekennzeichnet, daß Steuermittel (12) vorgesehen sind, die die Flankensteilheit vorgeben in Abhängigkeit von einer gewählten Betriebsart und/oder von Signalen von Sensormitteln (19, 20), die eine oder mehrere Betriebsgrößen erfassen.

6. Vorrichtung nach Anspruch 5 dadurch gekennzeichnet, daß ein erstes Sensormittel (20) die Temperatur einer Endstufe (18) erfaßt, die den Verbraucher (10) ansteuert. ·

7. Vorrichtung nach einem der Ansprüche 5 oder 6, dadurch gekennzeichnet, daß zweite Sensormittel (19) vorgesehen sind, die den Strom erfassen, mit dem der Verbraucher angesteuert wird oder sonstige Betriebsgrößen erfassen, deren Werte zur Bestimmung des Stromes dienen.

8. Vorrichtung nach einem der Ansprüche 5 bis 7, dadurch gekennzeichnet, daß der Verbraucher ein Antriebsmotor (10) eines Videorekorders ist und daß die Betriebsarten, die zur Bestimmung der Flankensteilheit dienen, die Betriebsarten des Videorekorders sind, wie Abspielbetrieb, Aufnahmebetrieb, Suchlauf, Umspulen oder dergleichen.

## Claims

1. Method of controlling a power dissipating device (10) using pulsed signals which vary between a first value (Uₕ) and a second value (Uₗ) in correspondence with a predetermined edge slope (a, b), characterised in that, the edge slope is predetermined in dependence on a selected operating mode and/or in dependence on one or more operating parameters.

2. Method in accordance with Claim 1, characterised in that, a first operating parameter is the temperature of a power output stage which is controlling the power dissipating device.

3. Method in accordance with either of Claims 1 and 2, characterised in that, a second operating parameter is the current with which the power dissipating device is controlled.

4. Method in accordance with any of the Claims 1 to 3, characterised in that, the power dissipating device is a drive motor for a video recorder and that the operating modes which serve for determining the edge slope are the operating modes of the video recorder such as the play back mode, recording mode, search mode, fast wind or the like.

5. Device for controlling a power dissipating device (10) using pulsed signals which vary between a first value (Uₕ) and a second value (Uₗ) in correspondence with a predetermined edge slope (a, b), characterised in that, there are provided control means (12) which define the edge slope in dependence on a selected operating mode and/or in dependence on signals from sensor means (19, 20) which detect one or more operating parameters.

6. Device in accordance with Claim 5, characterised in that, a first sensor means (20) detects the temperature of a power output stage (18) which is controlling the power dissipating device (10).

7. Device in accordance with either of Claims 5 or 6, characterised in that, second sensor means (19) are provided for detecting the current with which the power dissipating device is controlled or for detecting any sort of operating parameters whose values serve for determining the current.

8. Device in accordance with any of the Claims 5 to 7, characterised in that, the power dissipating device is a drive motor (10) for a video recorder and that the operating modes which serve for determining the edge slope are the operating modes of the video recorder such as the play back mode, recording mode, search mode, fast wind or the like.

## Revendications

1. Procédé de commande d'un consommateur (10) par application de signaux pulsés qui varie entre une première valeur (Uh) et une deuxième valeur (Uc) selon une pente (a, b) prédéterminée, caractérisé en ce que que la pente est prédéterminée en fonction du mode de fonctionnement choisi et/ou un ou plusieurs paramètres de fonctionnement.

2. Procédé selon la revendication 1, caractérisé en ce la température de l'étage de sortie qui commande le consommateur, constitue un premier paramètre de fonctionnement.

3. Procédé selon l'une des revendications 1 ou 2, caractérisé en ce que le courant servant à la commande du consommateur constitue un deuxième paramètre de fonctionnement.

4. Procédé selon l'une des revendications 1 à 3, caractérisé en ce que le consommateur est un moteur d'entraînement de magnétoscope et que les modes de fonctionnement, servant de base pour déterminer la pente, sont les modes de fonctionnement du magnétoscope, tel que lecture, enregristrement, recherche automatique, rembobinage etc.

5. Dispositif de commande d'un consommateur (10) par application de signaux pulsés qui passent d'une première valeur (Uh) à une deuxième valeur (Ul) selon un pente prédéterminée (a, b), caractérisé en ce que des unités de commande (12) sont prévues qui prédéfinissent la pente en fonction du mode de fonctionnement choisi et/ou des signaux émis par les capteurs (19, 20) qui détectent un ou plusieurs paramètre de fonctionnement.

6. Dispositif selon la revendication 5, caractérisé en ce qu'un premier capteur (20) détecte la température d'un étage de sortie (18) qui commande le consommateur.

7. Dispositif selon l'une des revendications 5 ou 6 caractérisé en ce que d'autres capteurs (19) sont prévus pour détecter le courant fourni au consommateur ou d'autres paramètres, dont les valeurs servent à déterminer le courant.

8. Dispositif selon l'une des revendications 5 à 7 caractérisé en ce que le consommateur est un moteur d'entraînement (10) d'un magnétoscope et que les modes de fonctionnement servant à déterminer la pente sont les modes de fonctionnement du magnétoscope, tels que lecture, enregistrement, recherche automatique, rembobinage etc.
